Europäisches Patentamt

European Patent Office

Office européen des brevets

(11) Publication number: **0 442 703 A2**

## EUROPEAN PATENT APPLICATION

(21) Application number: **91301127.6**

(22) Date of filing: **12.02.91**

(51) Int. Cl.⁵: **G03F 7/40**

(30) Priority: **16.02.90 US 481140**

(43) Date of publication of application:
**21.08.91 Bulletin 91/34**

(84) Designated Contracting States:
**AT BE CH DE FR GB IT LI NL SE**

(71) Applicant: **MORTON INTERNATIONAL, INC.**
**100 North Riverside Plaza, Randolph Street**
**at the River**
**Chicago, Illinois 60606(US)**

(72) Inventor: **Tara, Ming**
**1826 West Chateau Avenue**
**Anaheim, California 92804(US)**
Inventor: **Griguglio, James**
**1544 Miramar Drive**
**Balboa, California 92661(US)**

(74) Representative: **Bankes, Stephen Charles**
**Digby et al**
**BARON & WARREN 18 South End Kensington**
**London W8 5BU(GB)**

(54) Photoimageable compositions containing fugitive colorants.

(57) A photoimageable composition used for forming a solder mask on a printed circuit board contains a fugitive dye which can be rendered colorless by heat and/or UV radiation after a layer of the photoimageable composition has been exposed to patterned actinic radiation and developed.

EP 0 442 703 A2

The present invention is directed to photoimageable compositions useful in the printed circuit board industry and particularly to photoimageable compositions containing fugitive colorants; that is, colorants which can be rendered colorless by means of heat and/or radiation.

## BACKGROUND OF THE INVENTION

Solder masks are hard, permanent layers which overlie and protect the printed circuitry of printed wiring or circuit boards. Solder masks are generally patterned, covering major portions of a printed circuit board while leaving minor portions exposed to allow, for example, for soldering or otherwise electrically connecting the printed circuit board to other components.

In recent years it has become common to provide patterned solder masks by photoimaging techniques, similar to those used in forming the printed circuitry using primary photoresists. That is, a photoimageable layer is applied over the surface of a printed circuit board. This may be done in a variety of ways; for example, a liquid photoimageable composition may be coated onto the surface of a printed circuit board and allowed to harden thereon, e.g., by solvent evaporation. Alternatively, a photoimageable composition may be applied in the form of a dry film, as is described in U.S. Patent No. 4,889,790 issued 26 December 1989, the teachings of which are incorporated herein by reference. The photoimageable composition is exposed to patterned actinic radiation, e.g., by directing UV light through artwork. Subsequently, unexposed portions of the photoimageable composition are removed. Removal of the unexposed portions is accomplished with a developer which may be a solvent system, an aqueous medium or a mixture of a solvent and an aqueous system. After development, a solder mask is generally hardened in a post-cure step, e.g., by exposure to heat and/or UV light. Herein, "solder mask" is meant to describe a hard, permanent layer which meets the minimal abrasion resistant tests as defined in IPC-SM-84OB, Table 12, Summary of Criteria for Qualification/Conformance (Institute for Interconnecting and Packaging Electronic Circuits). A "solder mask-forming composition" is one capable of forming a solder mask which meets these minimal abrasion resistant criteria.

Photoimageable compositions useful for forming solder masks are described, for example, in U.S. Patent Nos. 3,726,679, 4,438,198, 4,601,973, 4,624,912, 4,786,579 and 4,789,620, the teachings of which are incorporated herein be reference.

A solder mask composition almost always contains a colorant or dye to provide color, such as the green commonly seen on printed circuit boards. The colorant permits visual inspection of a printed circuit board coated with a solder mask-forming composition, whereby defects in a photoimageable composition layer, such as pin-holes, bubbles, incomplete tenting of via holes, etc., can be detected prior to exposure, development and post-cure. The color, while permitting visual inspection of the photoimageable composition layer prior to exposure, hinders visualization of the underlying circuit board after development and post-cure. It may be desirable, for example, to be able to view the printed circuitry in order to visually inspect for defects, or it may be desirable to view non-circuitry printing on the board itself. There may even be aesthetic reasons for having a colorless solder mask.

The present invention addresses the need for color prior to exposure and development with a desire for a clear solder mask post-cure.

The invention is primarily directed to photoimageable compositions useful for forming solder masks because a solder mask is intended to remain on the printed circuit board. However, the invention is applicable to any photoimageable composition in which color is desirable prior to exposure, e.g., for inspection, and undesirable after exposure and development. For example, although primary resists are commonly stripped from a printed circuit board after exposure, development and formation of the printed circuitry (e.g., by etching), there may be processes in which the portions of the primary resist which remain after development are allowed to remain on the board; in which case, considerations similar to those with respect to solder masks apply.

## SUMMARY OF THE INVENTION

In accordance with the invention, a photoimageable composition, particularly a photoimageable composition useful for forming a solder mask, contains a colorant which is sufficiently stable to provide color to the photoimageable composition, prior to its being exposed to patterned actinic radiation, under conditions of heat and radiation to which the photoimageable composition is commonly subject prior to exposure, but which is degradable (rendered colorless) by harsher conditions of heat and/or radiation, particularly UV radiation, subsequent to exposure to patterned actinic radiation and development.

## DETAILED DESCRIPTION OF CERTAIN PREFERRED EMBODIMENTS

Photoimageable compositions useful in accordance with the invention contain a polymeric binder capable of forming a layer on a printed wiring or circuit board. A negative-acting photoimageable composition, such as one used to form a solder mask, contains a chemical system which is cross-linkable in a photo-initiated reaction. The photo-cross-linkable system may include the binder polymer, but generally includes one or more photosensitive monomers or short-chain oligomers. Negative-acting photoimageable compositions are soluble in a developer which may be a solvent or solvents, an aqueous solution or a miscible mixture of solvent and an aqueous medium;

however, upon exposure to actinic radiation, such compositions become insoluble in the particular developer. Thus, upon exposure to patterned actinic radiation, non-exposed portions of a photoimageable composition layer are washed from the printed circuit board, while exposed portions remain. Negative-acting photoimageable compositions generally contain a photoinitiator which promotes chemical cross-linking of the photo-cross-linkable system, e.g., by free-radical generation.

If the photoimageable composition is suitable for forming a solder mask, there is generally provided a chemical system for hardening the photoimageable composition remaining on the printed circuit board subsequent to exposure and development. The post-cure may be effected with heat and/or radiation, such as UV radiation of greater energy than was used for exposure. The post-cure may be an extension of the same chemical system that results in cross-linking during exposure, i.e., by causing previously unreacted molecules to react. Commonly, however, a photoimageable composition for forming a solder mask includes an additional chemical system which further cross-links the photoimageable composition during post-cure conditions of heat and/or radiation.

In accordance with the invention, photoimageable compositions include a fugitive colorant which provides color to the photoimageable composition layered on a printed circuit board prior to exposure and development, but is rendered colorless during post-development exposure to heat and/or radiation.

Heretofore, it is known to include stable dyes in photoimageable compositions, particularly those useful for forming solder masks. Such dyes permit visual inspection of the photoimageable composition layer that is coated on the circuit board (in light which does not initiate the exposure reactions). Such dyes also color the printed circuit board if left on the printed circuit board, as is the case with solder masks. Such colored solder masks detract from visibility of the printed circuit and any non-circuitry printing on the board. In the eyes of some, the color may detract from the aesthetics of the board.

An important advantage to a manufacturer of printed wiring or circuit boards is that a fugitive colorant provides an indicator of whether a circuit board has been hardened or cured. This minimizes the possibility that a printed circuit board will be either inadvertently left uncured or double cured. Mistakes of this nature are quite common in this industry.

The colorants and dyes of the present invention are selected to be rendered colorless, e.g., by chemical degradation, by the post-cure conditions of heat and/or radiation. The colorants are expected to be exposed to some heat and/or radiation prior to exposure. For example, a drying process in which solvent is evaporated from photoimageable composition may be facilitated with some heat. Likewise, it is common that photoimageable compositions for printed circuitry use may be viewed under yellow light without causing exposure reactions. Under such mild conditions of heat and/or radiation, the dye should be stable or sufficiently stable that the color enables visual inspection of the photoimageable layer on the board.

For each photoimageable composition, there will, of course, be a limit to the amount of heat and/or radiation that the composition can withstand without degradation, and a fugitive colorant used in conjunction with any particular photoimageable composition should be rendered colorless under conditions of heat and/or radiation far less harsh than those conditions which would degrade the photoimageable composition.

Most of the colorants contemplated for use in the present invention will not be rendered colorless or significantly so, even during the exposure step in which the photoimageable composition is exposed to patterned actinic radiation.

Subsequent to exposure and development, the portions photoimageable composition which remain on the printed circuit board may be subjected to much harsher conditions of heat and/or radiation, such as UV radiation, than conditions of heat and/or radiation prior to or during the exposure step. In fact, compositions useful for forming solder masks are generally hardened after development in a post-cure step or steps by exposure to heat and/or radiation. A fugitive dye is preferably selected which becomes colorless under the post-cure conditions of heat and/or radiation commonly used in conjunction with the post-cure of the particular composition.

It is inherent that any fugitive colorant be chemically compatible with the other components of the photoimageable composition. Applicants, however, are unaware of any particular compatibility problems that would be encountered with any of the commonly used photoimageable compositions for use with printed circuitry.

Because of the wide variety of photoimageable compositions used in conjunction with printed circuit boards, it is impossible to provide a set of standards for all cases regarding conditions of light and/or radiation under which a colorant should be stable for pre-exposure processing and should be rendered colorless during post-exposure processing. However, those with ordinary skill in the art should have no difficulty selecting appropriate dye base upon the pre-exposure conditions of heat and/or radiation and post-cure conditions of heat and/or radiation. Typically, pre-exposure processing e.g., a drying step, is carried out at temperatures of 90°C or below; whereas, post-cure steps take place at temperatures of upwards of about 100°C and more commonly upwards of 150°C. Typical exposure energies with UV light range from about 50 to about 450 milliJoules/cm². Prior to the exposure step, there is substantially no exposure to light which will render the dye colorless. On the other hand, post-cure UV exposure is typically from 3-5 Joules. Of course, the "harshness" of heat and/or radiation is also time-dependent.

The following general criteria for a fugitive colorant will suffice for most photoimageable compositions. In a 2.5 mil (0.06 mm) thick layer containing 0.05 wt% dye, less than about 10% of the dye should be degraded when exposed to temperatures of 80°C for one hour. If the colorant is heat-decomposable, at least about 90% should degrade when exposed to temperatures of 120°C for one hour. If the colorant is UV-degradable, at least about 90% should degrade when subjected to 4 Joules of UV energy. By "decomposable", is meant, chemically changed so as to destroy the color of the colorant.

The amount of colorant may vary upon over a wide range. Typically, no more colorant will be used than is necessary to provide easy visual inspection of the unexposed layer on the printed circuit board. Accordingly, the amount of colorant will depend on factors such as the color of the colorant, the intensity of the color provided by the colorant and the thickness of the layer of photoimageable composition to be applied. Generally, the amount of colorant will range from between about 0.005 wt.% of the composition and between about 0.5%; more generally between about 0.01 wt.% and about 0.5 wt.%.

Suitable fugitive colarants may be found in a variety of dye classes, including but not limited to diaryl methane. triacryl methane, xanthene, monoazo, diazo, nitro, anthraquinone and phenazine.

Dies within these classes which meet the above-criteria of a fugitive dye are useful in accordance with the invention. Specific examples of fugitive colorants are baso blue, malachite green, solvent violet (CI 42555:1), solvent blue 4 (CI 44045:1), solvent red 49 (CI 45170:1), disperse blue 14 (CI 61500), and solvent blue 36 (CI 61551); plus propietary dyes such as morplas violet (Morton Chemical), morplas emerald (Morton Chemical), neopen black X53 (BASF), atacryl blue (Atlantic Industries), and orasol brilliant red (Ciba-Geigy).

Generally, the fugitive colorant is added to the photoimageable composition in the usual manner that stable colorant or dye is currently added to a photoimageable composition. Typically, the solids of the photoimageable composition are dissolved in a solvent or in an aqueous medium, and it is preferred to use a dye which is soluble in the solvent or aqueous medium used.

A liquid photoimageable composition containing a fugitive colorant may be coated onto a printed circuit board in any of the usual manners, e.g., spray coating, curtain coating, screen printing, etc.; whereupon evaporation of the solvent or water leaves a photoimageable composition layer.

In accordance with another aspect of this invention, a dry film may be formed in which a photoimageable composition containing a fugitive colorant is applied to a support sheet which is sufficiently flexible to be wound into a roll. The pre-formed photoimageable composition layer is transferable from the support sheet to the surface of a printed circuit board. The photoimageable composition layer may be laid directly on the support sheet, but preferably, as described in above-referenced U.S. Patent No. 4,889,790, is laid on an intermediate layer which is selectively adherent to the photoimageable composition layer relative to its adherence to the support sheet. After application Of the photoimageable composition layer to the surface of a printed circuit board and removal of the support sheet, the intermediate layer becomes a top coat that protects the underlying photoimageable composition layer from mechanical contact and from oxidation. Typically, a dry film further contains a removable cover sheet on the outer surface of the photoimageable composition layer that enables the dry film to be wound into a roll without the photoimageable composition layer sticking to the back side of the support sheet.

The invention will now be described in greater detail by way of specific examples.

EXAMPLE 1

A photoimageable compositin was prepared containing the following components:

|  | Parts by Weight |
|---|---|
| Tris (2-hydroxethyl) Isocyanniate Triacrylate | 18.7 |
| Methylated Melamine | 3.4 |
| Hetron 912 (oligomer) | 6.2 |
| Novacure 3701 (oligomer) | 6.2 |
| Epoxy cresol novalac resin | 23.8 |
| Bisphenol A epoxy resin | 23.3 |
| 5-(2,5-dioxotetrahydrofunyl)-3-methyl-3-cyclohexene -1, 2-dicarbcxylic anhydride | 8.6 |
| 2,2 - dimethoxy-2-phenylacetophenone | 1.4 |
| 2-methyl-1-1[4-(methylthio)phenyl]-2-(4-morpholinyl)-1-propanone | 6.2 |
| Isopropylthioxanthone | 2.3 |
| Modaflow | 0.9 |
| Byk 361 | 0.8 |
| dye (Baso Blue) | .05 |
| Cabosil EH5 | 1.5 |
| MEHQ | 0.1 |
| Diethyleneglycol monoethyl ether acetate | |

This photoimageable composition was applied as a wet film via screen printing on a printed circuit board. The screen mesh was varied from 61 to 120 mesh polyester. The screened photoimageable composition was dried at 80° C. for 30 minutes, providing a non-tacky film. A diazo artwork was placed directly on the film, and the film was exposed to actinic radiation having an intensity of 350 mJ. for 1 minute. The film was developed in a basic aqueous solution, i.e., 1% by weight sodium carbonate monohydrate. The dye colored film was UV cured by exposure to actinic radiation having an intensity of 4 J. for 2 minutes to render colorless. Heat curing was at 150° C. for 1 hour.

EXAMPLE 2

The composition of Example 1 was processed as follows:

The photoimageable composition was applied at a wet film via a curtain coating process. The following coating conditions were used:

The photoimageable composition was diluted to a Zahn cup No. 5 reading 22-25 seconds, 25° C. This was equivalent to approximately 60 wt. percent solids. The coating speed was 80 to 90 meters per minute. The photoimageable composition was dried at 90° C. for 15 minutes, and cooled to room temperature. The second side was then coated in a manner identical to the first side. The second side was dried to a tack-free surface at 90° C. for 30 minutes. A diazo artwork was placed directly on the film, and the film was exposed to actinic radiation having an intensity of at least 350 mj. at the working surface for 1 minute. The film was developed in a basic aqueous solution, i.e., 1% by weight sodium carbonate monohydrate. The dye colored film was UV cured by exposure to actinic radiation having an intensity of 4 J for 2 minutes to render colorless. Heat curing was at 150° C. for 1 hour.

EXAMPLE 3

The composition of Example 1 was processed as follows:

The photoimageable composition was applied as a wet film via an electrostatic spray process. The following coating conditions were used:

The photoimageable composition was diluted to a Zahn cup No. 2 viscosity of 60-65 seconds using Butyl Cellosolve as the solvent. The boards were coated by conveyorized through an electrostatically charged atomization bell at 5 feet per minute. The photoimageable composition was charged via the application of 60,000 volts. The photoimageable composition was dried at 80° C. for 30 minutes, and cooled to room temperature. The second side was then coated in a manner identical to the first side. The second side was dried to a tack-free surface at 80° C. for 30 minutes. A diazo artwork was placed directly on the film, and the film was exposed to actinic radiation having an intensity of at least 350 mJ. at the working surface for 1 minute. The film was developed in a basic aqueous solution, i.e., 1% by weight sodium carbonate monohydrate. The dye colored film was UV cured by exposure to actinic radiation having an intensity of 4 J. for 2 minutes to render colorless. Heat curing was 150°C. for 1 hour.

EXAMPLE 4

A photoimageable composition was prepared containing the following components:

| | Parts by Weight |
|---|---|
| P301 (carbonylated acrylic copolymer) | 35.9 |
| Trimethylol Propane Triacrylate | 16.9 |
| Triethylene Glycol Diacrylate | 4.6 |
| 1,6 Hexanediol Diacrylate | 7.8 |
| Novacure 3701 oligomer | 14.5 |
| Methylated Melamine | 5.8 |
| 2,2-dimethoxy-2-phenyl acetophenone | 1.7 |
| 2-methyl-1-[4-(methylthio)phenyl]-2-(4-morpholinyl)-1-propanone | 1.4 |
| Isopropyl thioxanthone | .5 |
| Talc | 8.1 |
| Antimony trioxide | 1.1 |
| Decobromo Diphenyl Oxide | 1.4 |
| Malachite Green | .1 |
| Modaflow | .15 |
| MEHQ | .05 |
| Methyl ethyl ketone | |

The photoimageable composition was applied as a wet film to a base sheet so as to form a dry film. A wet film of 6 mil thickness was applied by draw down to a polyester sheet. The solvent evaporated from the film which was covered with a polyethylene sheet. The film was applied to the circuit board by hot roll lamination or by vacuum lamination. The diazo artwork was placed directly on the polyester sheet during imaging, but before developing the polyester sheet was removed. The film was exposed to actinic radiation having an intensity of at least 350 mJ. at the working surface for 1 minute. The film was developed in a basic aqueous solution. i.e., 1% by weight sodium carbonate monohydrate. The dye colored film was UV cured by exposure to actinic radiation having an intensity of 4 J. for 2 minutes to render colorless. Heat curing was at 150°C. for 1 hour.

While the invention has been described in terms of certain preferred embodiments, modifications obvious to one with ordinary skill in the art may be made without departing from the present invention. For example, while the invention has discussed fugitive colorants as those being rendered colorless with sufficiently harsh conditions of heat and/or UV radiation, it is contemplated that a colorant might be used that is rendered colorless by a different type of radiation.

Various features of the invention are set forth in the following claims.

## Claims

1. A photoimageable composition applicable as a layer on a printed circuit board, or a board for making a printed circuit, said photoimageable composition being soluble in a developer and comprising a polymeric binder and a chemical system which upon exposure to actinic radiation causes the composition to become insoluble in said developer, characterised in that it contains a fugitive colorant which may be rendered colorless by exposure to heat and/or radiation, whereby a layer of said photoimageable composition may be exposed to patterned actinic radiation, developed in said developer to selectively remove unexposed portions of said layer, and then exposed to sufficient heat and/or radiation to render said unremoved exposed portions of said photoimageable composition layer colorless.

EP 0 442 703 A2

2. A photoimageable composition according to claim 1 which may be used to form a solder mask.

3. A photoimageable composition according to claim 1 or claim 2 wherein said photoimageable composition, after exposure to patterned actinic radiation and development in said developer, is post-curable under a set of conditions of heat and/or radiation to harden said unremoved portions of said layer; and said fugitive colorant is selected to be rendered colorless under said set of conditions.

4. A photoimageable composition according to any preceding claim wherein said fugitive colorant is of a type which is rendered colorless by heat.

5. A photoimageable composition according to claim 4 wherein said fugitive colorant is of a type which at a 0.05 wt.% concentration in a 2.5 mil (63.5 $\mu$m) thick photoimageable composition layer is degraded no more than 10% at 80°C for one hour but is degraded at least 90% when exposed to temperatures of 120°C for one hour.

6. A photoimageable composition according to any one of claims 1 to 3 wherein said fugitive colorant is of a type which is rendered colorless by radiation.

7. A photoimageable composition according to claim 6 wherein said fugitive colorant is of a type which is rendered colorless by actinic radiation.

8. A photoimageable composition according to claim 6 wherein said fugitive colorant is of a type which is rendered colorless by UV radiation.

9. A photoimageable composition according to claim 8 wherein said fugitive colorant is of a type which at a 0.05 wt.% concentration in a 2.5 mil (63.5 $\mu$m) think photoimageable composition layer is degraded no more than 10% at 80°C for one hour but is degraded at least 90% when subjected to 4 Joules of UV energy.

10. A photoimageable composition according to any preceding claim wherein said fugitive colorant is selected from baso blue, malachite green, solvent violet, solvent blue 4, solvent red 49, disperse blue 14, and solvent blue 36, morplas violet, morplas emerald, neopen black X53, atacryl blue and orasol brilliant red and mixtures thereof.

11. A dry film comprising:
   a support sheet,
   a layer of photoimageable composition on said support sheet, said photoimageable composition being soluble in a developer, said photoimageable composition comprising a polymeric binder and a chemical system which upon exposure to actinic radiation causes said photoimageable composition to become insoluble in said developer, characterised in that said photoimageable composition contains a fugitive colorant which may be rendered colorless by exposure to heat and/or radiation, whereby a layer of said photoimageable composition may be exposed to patterned actinic radiation, developed in said developer to selectively remove unexposed portions of said layer, and then exposed to sufficient heat and/or radiation to render said unremoved portions of said photoimageable composition layer colorless.

12. A dry film according to claim 11 further comprising an intermediate layer between the support sheet and the photoimageable composition layer, said intermediate layer being selectively adherent to said layer of photoimageable composition relative to its adherence to said support sheet.

7